(19) **Europäisches Patentamt**
**European Patent Office**
**Office européen des brevets**

(11) **EP 2 039 798 B1**

(12) **EUROPEAN PATENT SPECIFICATION**

(45) Date of publication and mention
of the grant of the patent:
**25.01.2012 Bulletin 2012/04**

(51) Int Cl.:
*C23C 14/34* (2006.01)     *C04B 35/457* (2006.01)
*G02F 1/1343* (2006.01)     *H01B 5/14* (2006.01)
*H01B 13/00* (2006.01)

(21) Application number: **07744954.4**

(22) Date of filing: **08.06.2007**

(86) International application number:
**PCT/JP2007/061638**

(87) International publication number:
**WO 2007/142330 (13.12.2007 Gazette 2007/50)**

(54) **TRANSPARENT CONDUCTIVE FILM, PROCESS FOR PRODUCTION OF THE FILM, AND SPUTTERING TARGET FOR USE IN THE PRODUCTION OF THE FILM**

TRANSPARENTER LEITFÄHIGER FILM, VERFAHREN ZUR HERSTELLUNG DES FILMS UND SPUTTERTARGET ZUR VERWENDUNG BEI DER HERSTELLUNG DES FILMS

FILM CONDUCTEUR TRANSPARENT, SON PROCÉDÉ DE PRODUCTION ET CIBLE DE PULVÉRISATION CATHODIQUE DESTINÉE À LA PRODUCTION DUDIT FILM

(84) Designated Contracting States:
**DE**

(30) Priority: **08.06.2006 JP 2006159526**

(43) Date of publication of application:
**25.03.2009 Bulletin 2009/13**

(73) Proprietor: **Asahi Glass Company, Limited**
**Chiyoda-ku**
**Tokyo 100-8405 (JP)**

(72) Inventors:
• **ODAKA, Hidefumi**
**Tokyo 100-8405 (JP)**
• **MITSUI, Akira**
**Tokyo 100-8405 (JP)**

• **NAKAGAMA, Susumu**
**Takasago-shi, Hyogo 676-0074 (JP)**

(74) Representative: **Müller-Boré & Partner**
**Patentanwälte**
**Grafinger Straße 2**
**81671 München (DE)**

(56) References cited:
**WO-A1-2005/078152     WO-A1-2007/055231**
**JP-A- 2000 273 622     JP-A- 2000 281 431**

• **FILHO F M ET AL: "Influence of Ta2O5 on the electrical properties of ZnO- and CoO-doped SnO2 varistors" CERAMICS INTERNATIONAL, ELSEVIER, AMSTERDAM, NL, vol. 30, no. 8, 1 January 2004 (2004-01-01), pages 2277-2281, XP004612420 ISSN: 0272-8842**

**Description**

The present invention relates to a tin oxide sputtering target which is preferably used for forming a transparent conductive film by DC sputtering method, DC pulse sputtering method or AC sputtering method.

Further, the present invention relates to a transparent conductive film which is preferably used for transparent electrodes for a flat panel display (FPD) and a method for producing the transparent conductive film.

The transparent conductive film of the present invention can preferably be formed by using the above sputtering target of the present invention.

Heretofore, transparent conductive films are used as transparent electrodes formed on a substrate in FPD such as a liquid crystal display (LCD), a plasma display panel (PDP) or an electroluminescence display (ELD) containing an organic EL. As materials for such transparent conductive films, indium oxide, zinc oxide and tin oxide are known. As the indium oxide, ITO (tin doped-indium oxide) is particularly popular and widely used. The reason why ITO is widely used resides in its low resistance and an excellent patterning property. However, a reserve of indium is poor, and it is desired to develop an alternative material.

Tin oxide ($SnO_2$) is a material expected as the alternative material. However, it is necessary to use antimony having a strong toxicity as a dopant to impart conductivity to tin oxide (for example, Patent Document 1).

Patent Document 1: JP-A-10-330924

JP-A-2000-281431 discloses a tin dioxide-based sintered compact, wherein at least one kind of Al, Si, Nb, Ta, and Y is added to an $SnO_2$-based powder, which is used for the preparation of a material for thin film formation and electroconductive film.

JP-A-2000-273622 discloses a material for forming a thin film, wherein an $SnO_2$ sintered body is incorporated with one or more kinds among Ga, Bi, Nb, Mn, Fe, Ni, Co and Ta by $\leq 20$ wt.%, expressed in terms of oxides.

WO-A-2005/078152 discloses a sputtering target, characterized in that it is comprised of an $In_2O_3$-ZnO-$SnO_2$ composite oxide, whose main component is $SnO_2$ compounded with an oxide of any one or both of Ta and Y elements, and a thin film for optical information recording medium, as well as a process for producing the same, and a sputtering target for use therein.

As a dopant other than antimony, tungsten, tantalum, etc. have been studied (for example, Applied Physics Letters, vol. 78, No. 3, p350 (2001)).

However, in a case where a sputtering target is produced by employing only tin oxide containing tungsten or tantalum, there is a problem that its sintered density is low, and therefore for forming a transparent conductive film, DC sputtering method, DC pulse sputtering method and AC sputtering method, which are excellent in productivity, cannot be used.

On the other hand, a tin oxide target which can be used for DC sputtering, DC pulse sputtering and AC sputtering has been studied, and its realization has been shown (for example, JP-A-2005-154820). However, a film formed by employing a target shown in the above document has a high electric resistance, and a thin film which realizes a specific resistance of at most 5E-2$\Omega$ cm, required for an alternative material for ITO, has not been obtained.

It is an object of the present invention to provide a tin oxide target which is suitable for forming a transparent conductive film by DC sputtering method, DC pulse sputtering method or AC sputtering method.

Further, it is an object of the present invention to provide a transparent conductive film preferably formed by using the above tin oxide target and a method for producing the transparent conductive film.

The present invention provides a sputtering target which is used for forming a transparent conductive film by a sputtering method, consisting of tin oxide as the main component, and at least one element selected from the A dopant group consisting of zinc, titanium, magnesium and zirconium and at least one element selected from the B dopant group consisting of tungsten, tantalum and molybdenum, as dopants and containing no antimony or indium.

The sputtering target of the present invention preferably satisfies the following formulae (1) to (3):

$$0.8 < (Sn)/(Sn+M_A+M_B) < 1.0 \qquad (1)$$

$$0.001 < (M_A)/(Sn+M_A+M_B) < 0.1 \qquad (2)$$

$$0.001 < (M_B)/(Sn+M_A+M_B) < 0.15 \qquad (3)$$

where $M_A$ is the total amount of elements of the A dopant group, $M_B$ is the total amount of elements of the B dopant group, and Sn is the amount of tin element contained in the sputtering target.

The sputtering target of the present invention preferably has the relative density of at least 60% and the sheet resistance on its surface of at most $9E+6\Omega/\square$.

The present invention provides a transparent conductive film, consisting of tin oxide as the main component, and at least one element selected from the A dopant group consisting of zinc, titanium, magnesium and zirconium and at least one element selected from the B dopant group consisting of tungsten, tantalum and molybdenum, as dopants and containing no antimony or indium.

The transparent conductive film of the present invention preferably satisfies the following formulae (4) to (6):

$$0.8 < (Sn)/(Sn+M_A+M_B) < 1.0 \qquad (4)$$

$$0.001 < (M_A)/(Sn+M_A+M_B) < 0.1 \qquad (5)$$

$$0.001 < (M_B)/(Sn+M_A+M_B) < 0.15 \qquad (6)$$

where $M_A$ is the total amount of elements of the A dopant group, $M_B$ is the total amount of elements of the B dopant group, and Sn is the amount of tin element contained in the transparent conductive film.

The transparent conductive film of the present invention preferably has the specific resistance of at most $5E-2\Omega$ cm.

The transparent conductive film of the present invention preferably has a thickness of at most 1 $\mu$m.

Further, the present invention provides a display member, which has the transparent conductive film of the present invention.

Further, the present invention provides a method for producing a transparent conductive film, which comprises forming the transparent conductive film of the present invention by a sputtering method using the sputtering target of the present invention.

The sputtering target of the present invention has a high sintered density and a low surface sheet resistance and thereby is preferably used as a sputtering target for forming a transparent conductive film by DC sputtering method, DC pulse sputtering method and AC sputtering method.

A transparent conductive film formed by using the sputtering target of the present invention is comparable to conventional transparent conductive films in the properties required for transparent electrodes of FPD such as relative resistance or visible light transmittance.

Further, since a transparent conductive film to be formed does not contain expensive indium, it is possible to provide a transparent conductive film with a low cost. Further, since antimony and indium having toxicity are not contained, it is excellent from the viewpoint of environment.

BEST MODE FOR CARRYING OUT THE INVENTION

The sputtering target of the present invention is characterized by consisting of tin oxide as the main component and at least one element selected from the A dopant group consisting of zinc, titanium, magnesium and zirconium and at least one element selected from the B dopant group consisting of tungsten, tantalum and molybdenum as dopants and containing no antimony or indium. Further, "consisting of tin oxide as the main component" means that the content of tin oxide is at least 75 mol% as calculated as tin element. More specifically, in the metal elements constructing a target, the ratio of tin element is preferably at least 75 mol%, more preferably at least 80 mol%.

In the sputtering target of the present invention, the element of the B dopant group (tungsten, tantalum and molybdenum) is contained as a dopant in a sintered target consisting of tin oxide as the main component (hereinafter, may sometimes referred to as "tin oxide target") in order to impart conductivity to a film formed by sputtering.

Here, as the element of the B dopant group, In or Ga, which has been conventionally used as the dopant for tin oxide target, is not preferred. Because such a dopant has a problem that oxygen pores are formed in a film, and carrier is formed, and therefore if the film is exposed to a high temperature, the electric resistance of the film becomes high.

However, tin oxide targets containing only the B dopant group element cannot be used for forming transparent electrodes for FPD by DC sputtering method, DC pulse sputtering method or RF sputtering method due to any one of the following reasons.

> (1) Since the sintered density of a target is low, sufficient mechanical strength cannot be obtained, and the target cannot be molded (mechanically processed) to a target for sputtering. The reason why the sintered density of the target containing only the B dopant group element is low resides in that tin oxide powders are not sufficiently be bonded to one another.
> (2) Even if the target can be molded to a target for sputtering, the sheet resistance of a target to be obtained is high, and DC electric discharge, DC pulse electric discharge and AC electric discharge thereby cannot be carried out.

The reason why the sheet resistance of the target containing only the B dopant group on a film surface is high also resides in that tin oxide powders cannot sufficiently be bonded to one another, and electric loss results at the vicinity of binding interface of powders.

In the case of the sputtering target of the present invention, the tin oxide target contains the A dopant group element (zinc, titanium, magnesium and zirconium) as a dopant in addition to the B dopant group element, and the target thereby can be used for DC sputtering, DC pulse sputtering, and RF sputtering. Specifically, since the sintered density of the target is high, the target has a sufficient mechanical strength so as to be molded to a target for sputtering. Further, since the surface resistance of the target, specifically the sheet resistance of the target is sufficiently low, DC sputtering, DC pulse sputtering and AC sputtering can be carried out.

The sputtering target of the present invention may contain one element selected from the A dopant group or may contain at least two elements selected from the A dopant group. Similarly, the sputtering target of the present invention may contain one element selected from the B dopant group or at least two elements selected from the B dopant group.

Among the elements of the A dopant group, zinc is preferably contained since the higher sintered density can be obtained.

On the other hand, among the B dopant group, tantalum is preferably contained since the lower resistance can be obtained.

The sputtering target of the present invention preferably satisfies the following formulae (1) to (3):

$$0.8 < (Sn)/(Sn+M_A+M_B) < 1.0 \qquad (1)$$

$$0.001 < (M_A)/(Sn+M_A+M_B) < 0.1 \qquad (2)$$

$$0.001 < (M_B)/(Sn+M_A+M_B) < 0.15 \qquad (3)$$

where $M_A$ is the total amount of elements of the A dopant group, $M_B$ is the total amount of elements of the B dopant group, and Sn is the amount of tin element contained in the sputtering target. In the present invention $M_A$, $M_B$ and Sn are represented by mol%, unless otherwise specified.

When the sputtering target of the present invention satisfies the above formulae (1) to (3), a target having a relative density of at least 60% obtained by the following formula (7) can be easily obtained.

$$\text{Relative density (\%)} = (\text{bulk density/true density}) \times 100 \qquad (7)$$

Here, bulk density $(g/cm^3)$ is an actually measured density obtained from the size and weight of a produced target, and true density is a theoretical density obtained by calculating a theoretical density specific to substance.

When the relative density of the sputtering target is at least 60%, the target has a sufficient mechanical strength for molding it to a target for sputtering.

Further, when the sputtering target of the present invention satisfies the above formulae (1) to (3), the sheet resistance of the target surface tends to be at most $9E+6\Omega/\square$. Here, "E+6" means $10^6$. When the sheet resistance of the target surface is at most $9E+6\Omega/\square$, the surface resistance of the target is sufficiently low, and the target is suitable as a target for sputtering by DC sputtering, DC pulse sputtering or RF sputtering.

The relative density of the sputtering target is preferably at least 60%, more preferably at least 80%.

The sheet resistance of the sputtering target surface is preferably at most $9E+6\Omega/\square$, more preferably at most $1E+6\Omega/\square$.

The sputtering target of the present invention preferably satisfies the following formulae (8) to (10):

$$0.75<(Sn)/(Sn+M_A+M_B)<0.98 \qquad (8)$$

$$0.003<(M_A)/(Sn+M_A+M_B)<0.08 \qquad (9)$$

$$0.05<(M_B)/(Sn+M_A+M_B)<0.20 \qquad (10)$$

where $M_A$, $M_B$ and Sn are as defined above.

Further, the formula (8) preferably satisfies the following formula (8'), particularly preferably satisfies the following formula (8").

$$0.75<(Sn)/(Sn+M_A+M_B)<0.95 \qquad (8')$$

$$0.80<(Sn)/(Sn+M_A+M_B)<0.95 \qquad (8'')$$

The sputtering target of the present invention can be produced by a conventional procedure for forming a sintered oxide target. Namely, the sputtering target of the present invention can be produced by preparing materials so as to have the desired composition, followed by molding under applied pressure and then by sintering in an atmosphere at a high temperature (for example, 1,200°C) under atmospheric pressure.

At a high temperature, firing must be carried out under atmospheric pressure. Under a reduced pressure or in an argon atmosphere, tin oxide tends to decompose and evaporate, and it is thereby difficult to dense the target. Therefore, in such a case, sintering is preferably carried out in an atmosphere containing oxygen, such as air. For example, sintering is carried out in air at a temperature of 1,000 to 1,600°C.

In the case of sintering in air, a target may, for example, be produced in the following manner. $SnO_2$ powder and oxide powders of respective dopants are prepared and mixed in a predetermined ratio. At that time, with water as a dispersant, they are mixed by a wet type ball mill method. Then, the mixed powder is dried, packed in a rubber mold and pressure-molded by a cold isostatical press machine (CIP machine) at pressure of $1,500 \text{ kg/cm}^2$. Then, sintering is carried out in air at a temperature of 1,000 to 1,600°C to obtain a sintered body. The sintered body is mechanically processed to a desired size to produce a target material. The target material is metal-bonded on a backing plate made of a metal such as copper, whereby the target is produced.

The particle size of $SnO_2$ powder is preferably at most 10 $\mu$m, more preferably at most 5 $\mu$m as the average particle size. It is further preferably at most 1 $\mu$m. Further, the average particle size of oxide powders of respective dopants is preferably at most 30 $\mu$m, more preferably at most 5 $\mu$m. When the crystal size of the sintered body obtained by the above procedure is measured by SEM, it is confirmed that the sintered body is from 1 to 50 $\mu$m. Further, in the present invention, the average particle size means a central value of the particle size distribution of the powder.

The transparent conductive film of the present invention is characterized by consisting of tin oxide as the main component, and at least one element selected from the A dopant group consisting of zinc, titanium, magnesium and zirconium and at least one element selected from the B dopant group consisting of tungsten, tantalum and molybdenum, as dopants and containing no antimony or indium. Here, "consisting of tin oxide as the main component" means that the content of tin oxide is at least 75 mol%, preferably at least 80 mol% as calculated as tin element. The transparent conductive film of the present invention is suitable for transparent electrodes for FPD such as PDP.

The transparent conductive film of the present invention is formed by preferably carrying out DC sputtering, DC pulse sputtering or RF sputtering by using the sputtering target of the present invention.

In general, as a method for forming a large area film, a sputtering method, in which a uniform thin film can be easily obtained, and pollution is little, is suitable. The sputtering method is generally classified into a high frequency (RF) sputtering method using a high frequency power source, a direct current (DC) sputtering method using a direct current, a direct current (DC) pulse sputtering method and an alternative current (AC) sputtering method using alternating current. The RF sputtering method is excellent, since an insulating material can be used as a target, however, a high frequency current power source is expensive, and its structure is complicate. And, the RF sputtering method is not suitable for forming a film with a large area.

On the other hand, in the case of the DC sputtering method, DC pulse sputtering method and AC sputtering method, although target materials are limited to a material having an excellent conductivity, a direct current or alternating current is used, and the structure of apparatus is thereby simple, and they have advantage from the viewpoint of controlling the film thickness. Accordingly, as an industrial method for forming film, the DC sputtering method, DC pulse sputtering method and AC sputtering method, which are excellent in productivity are preferred. Further, as the sputtering method, without using the RF sputtering, using the DC sputtering method, DC pulse sputtering method or AC sputtering method is one of important factors for feasibility assessment of a business from the viewpoint of productivity.

Further, the method for producing the transparent conductive film of the present invention is not particularly limited, so far as the above characteristics are satisfied. Accordingly, the transparent conductive film of the present invention may be produced by another sputtering method such as a RF sputtering method or may be produced by using another film forming method such as a CVD method, sol-gel method or PLD method.

In a case where a film is formed by the sputtering method, the sputtering is preferably carried out in an oxidative atmosphere. The oxidative atmosphere is an atmosphere containing an oxidative gas. The oxidative gas means a gas containing oxygen atoms such $O_2$, $H_2O$, CO or $CO_2$. The concentration of the oxidative gas influences properties of the film such as conductivity or transmittance of the film. Accordingly, it is necessary to optimize the concentration of the oxidative gas depending on a condition such as the apparatus, temperature of substrate or sputtering pressure.

As the gas for sputtering, Ar-$O_2$ gas (mixed gas containing Ar and $O_2$) or Ar-$CO_2$ gas (mixed gas containing Ar and $CO_2$) is preferred, since the composition of gas can be easily controlled for forming a transparent film of which the resistance is low. Particularly, Ar-$CO_2$ gas is preferred from the viewpoint of the controllability.

In the case of the Ar-$O_2$ gas, the concentration of $O_2$ is preferably from 1 to 25 vol% so that a transparent low resistance film can be formed. If the concentration of $O_2$ is less than 1 vol%, the film may be colored yellow, and the resistance of the film may be high. If the concentration of $O_2$ exceeds 25 vol%, the resistance of the film may be high.

Further, in the case of the Ar-$CO_2$ gas, the concentration of $CO_2$ is preferably from 10 to 50 vol% so that a transparent low resistance film can be formed. If the concentration of $CO_2$ is less than 10 vol%, the film may be colored yellow, and the resistance of the film may be high. If the concentration of $CO_2$ exceeds 50 vol%, the resistance of the film may be high. However, in some applications, a colored film or a high resistance film may sometimes be required. In such a case, the respective concentrations are not limited to the above ranges.

For example, the transparent conductive film of the present invention may be produced by the following method. By using a magnetron DC sputtering apparatus and the above target, the chamber is vacuumed to $10^{-7}$ to $10^{-4}$ Torr. If the pressure in the chamber exceeds $10^{-4}$ Torr, it is difficult to control the resistance due to influence of a moisture reside remaining in vacuum. Further, if the pressure in the chamber is less than $10^{-7}$ Torr, the time required for vacuuming becomes long, and the productivity deteriorates. The electric power density (a value obtained by dividing the applied electricity by the area of the target surface) at the time of the sputtering is preferably from 1 to 10 w/cm$^2$. If the electric power density is less than 1 W/cm$^2$, electric discharge is not stable. If the electric power density exceeds 10 W/cm$^2$, the possibility of breakage due to heat generated from the target may be high. The sputtering pressure is preferably from $10^{-4}$ to $10^{-1}$ Torr. If the sputtering pressure is less than $10^{-4}$ Torr, or the sputtering pressure exceeds $10^{-1}$ Torr, the electric discharge tends not to be stable.

The transparent conductive film of the present invention preferably satisfies the following formulae (4) to (6):

$$0.8 < (Sn)/(Sn+M_A+M_B) < 1.0 \qquad (4)$$

$$0.001 < (M_A)/(Sn+M_A+M_B) < 0.1 \qquad (5)$$

$$0.001 < (M_B) / (Sn+M_A+M_B) < 0.15 \qquad (6)$$

where $M_A$ is the total amount of elements of the A dopant group, $M_B$ is the total amount of elements of the B dopant group, and Sn is the amount of tin element contained in the transparent conductive film.

When the above (4) to (6) are satisfied, a transparent conductive film having specific resistance value of at most $5E-2\Omega$ cm can easily be obtained, which is suitable for transparent electrodes for FPD. The specific resistance of the transparent conductive film is more preferably at most $1.0E-2\Omega$ cm, further preferably at most $0.5E-2\Omega$ cm.

The film thickness of the transparent conductive film of the present invention is preferably at most 1 $\mu$m. When the film thickness is at most 1 $\mu$m, optical defects of the transparent conductive film such as haze can be prevented. The film thickness of the transparent conductive film is more preferably at most 0.4 $\mu$m, further preferably at most 0.25 $\mu$m.

It is preferred that the transparent conductive film of the present invention is excellent in transparency. Specifically, visible transmittance is preferably at least 80%, more preferably at least 85%.

Since the transparent conductive film of the present invention does not contain expensive indium, it is possible to provide a transparent conductive film at a low cost. Further, since the transparent conductive film of the present invention does not contain antimony or indium, the transparent conductive film is environmentally excellent, and the specific resistance becomes low. The content of indium element contained in the transparent conductive film is preferably at most 0.1%. Further, the content of antimony element contained in the transparent conductive film is preferably at most 0.1%.

In order to further lower the specific resistance of the transparent conductive film, the transparent conductive film of the present invention preferably satisfies the following formulae (11) to (13):

$$0.75 < (Sn) / (Sn+M_A+M_B) < 0.98 \qquad (11)$$

$$0.003 < (M_A) / (Sn+M_A+M_B) < 0.08 \qquad (12)$$

$$0.05 < (M_B) / (Sn+M_A+M_B) < 0.20 \qquad (13)$$

Further, the formula (11) preferably satisfies the following formula (11'), particularly preferably the following formula (11''):

$$0.75 < (Sn) / (Sn+M_A+M_B) < 0.95 \qquad (11')$$

$$0.80 < (Sn) / (Sn+M_A+M_B) < 0.95 \qquad (11'')$$

In the formulae (11) to (13), $M_A$, $M_B$ and Sn are as defined in the formulae (4) to (6).

The display member of the present invention is a substrate for FPD such as PDP, particularly one used as a front substrate of FPD. For example, a glass substrate or a resin substrate on which the transparent conductive film of the present invention is formed as transparent electrodes may be mentioned.

The glass substrate is not particularly limited and for example, conventional various glass substrates (soda-lime glass, non-alkali glass, etc.) may be used. As one of preferred embodiments, a high distortion glass for PDP may be mentioned. Further, its size or thickness is not particularly limited. For example, a glass of which length and width are about from 400 to 3,000 mm respectively may preferably be used. Further, its thickness is preferably from 0.7 to 3.0 mm, more preferably from 1.5 to 3.0 mm.

The display member of the present invention may be used as a substrate for various FPD in addition to PDP. The FPD may, for example, be a liquid crystal display (LCD), electroluminescence display (ELD) containing an organic EL or field emission display (FED).

EXAMPLES

Now, the present invention will be described in further detail with reference to Examples. However, the present invention is by no means restricted to such specific Examples. Namely, the comprehensive range of the present invention is defined by the claims and includes various embodiments in addition to the following Examples. It should be noted that examples including niobium are for reference purposes only.

EXAMPLES 1 to 8

By using $SnO_2$, $Ta_2O_5$, $WO_3$, $ZnO$ and $Nb_2O_5$ powders having a purity of about 99.9% and a particle size of at most 5 $\mu$m, a powder was prepared so that the composition ratio of the respective metal elements becomes the composition ratio shown in Table 1. The powder was mixed by means of a ball mill, pressure-molded and sintered for four hours in the atmosphere at 1,450°C, and the sintered oxide body was processed into a target shape by a machine. The composition, the relative density and the surface resistance (sheet resistance of the surface) of the obtained sintered oxide body are shown in Table 1. The sheet resistance of the surface of the target was measured by a surface resistance measuring apparatus (LORESTA, manufactured by Mitsubishi Petrochemical Co., Ltd.). Further, the relative density was obtained by the following formula (7).

$$\text{Relative density (\%) = (bulk density/true density)} \times 100 \qquad (7)$$

Here, bulk density ($g/cm^3$) is an actually measured density obtained from the size and weight of a produced target, and true density is a theoretical density obtained by calculating a theoretical density specific to substance.
A high distortion glass having a thickness of 2.8 mm (PD200, manufactured by Asahi Glass Company, Limited, visible transmittance of a substrate: 91%) was prepared as a glass substrate. The glass substrate was washed and then set on a substrate holder of the sputtering apparatus. Further, a sintered oxide target having the composition shown in Table 1 was set on a cathode of magnetron DC sputtering apparatus. The inside of a film forming chamber of the sputtering apparatus was evacuated, and a film containing tin oxide as the main component and having the thickness of about 150 nm was formed on the glass substrate. As the sputtering gas, a mixed gas containing argon and oxygen was used. The temperature of the substrate was 250°C. The pressure at the time of film forming was 0.5 Pa.
By changing the flow ratio of argon gas and oxygen gas, it was possible to form a transparent low electric resistance thin film. Table 2 shows the composition, visible transmittance and specific resistance of films which were formed by controlling the gas ratio so that the electric resistance became the lowest. Here, the composition, visible transmittance and specific resistance of films were measured by the following methods.

(1) Composition: A film having a thickness of 300 nm was produced under the same process condition as in the case of the film formation on the glass substrate. A fluorescent amount emited from metal elements in the formed film was measured by a fluorescent X ray apparatus (RIX3000, manufactured by Rigaku Industrial Corp.), and the amounts of the respective metal elements and the composition ratio were calculated by fundamental parameter theoretical calculation.
(2) Visible light transmittance: In accordance with JIS-R3106 (year 1998), by using a spectrophotometer (U-4100, manufactured by Shimadzu Corporation), visible light transmittance of the glass substrate with the film was calculated from transmittance spectral of the glass substrate with the formed film.
(3) Specific resistance: The specific resistance was measured by a surface resistance measuring apparatus (LORESTA, manufactured by Mitsubishi Petrochemical Co., Ltd.).

From Table 1, it is evident that each of the sintered oxide targets obtained in Examples 1 to 10 has a relative density of at least 60% and a surface resistance of at most 9E+6Ω/□. Therefore, they can be used for DC sputtering method, DC pulse sputtering method and Ac sputtering method. Further, from Table 2, it is evident that each of the films formed in Examples 1 to 10 has a visible light transmittance of at least 85% and a specific resistance of at most 1E-2Ω cm. Therefore, they have appropriate properties required for transparent electrodes for FPD such as PDP.

COMPARATIVE EXAMPLES 1 to 5

Sintered oxide targets having the compositions shown in Table 1 were produced in the same manner as in Examples. Further, in Comparative Examples 4 and 5, a powder ($In_2O_5$ and $Ga_2O_3$) having a purity of about 99.9% and a particle size of at most 5 μm was used.

As a result, the sintered density of each sintered oxide target containing no element of the A dopant group (Comparative Examples 1 to 3) was low at a level of at most 60%, and when each of the sintered bodies of Comparative Examples was processed into a target shape by machine, breakage resulted, and it could not be processed into a target. On the other hand, targets containing indium or gallium as the B dopant group element (Comparative Examples 4 and 5) had a high sintered density and showed a sheet resistance useful for DC sputtering. However, a film formed by using such a target had a high specific resistance as shown in Table 2, and it was not useful for transparent electrodes for FPD.

TABLE 1: Composition, density and electric resistance of target

| | Used element | $(Sn) / (Sn+M_A+M_B)$ | $(M_A) / (Sn+M_A+M_B)$ | $(M_B) / (Sn+M_A+M_B)$ | Target density (%) | Surface resistance ($\Omega/\square$) |
|---|---|---|---|---|---|---|
| Ex. 1 | $M_A$=Zn $M_B$=Ta | 0.961 | 0.009 | 0.029 . | 60.3 | 0.3M |
| Ex. 2 | $M_A$=Zn $M_B$=Ta | 0.926 | 0.009 | 0.065 | 60.7 | 0.3M |
| Ex. 3 | $M_A$=Zn $M_B$=Ta | 0.887 | 0.0010 | 0.103 | 73 | 0.02k |
| Ex. 9 | $M_A$=Zn $M_B$=Ta | 0.950 | 0.010 | 0.040 | 99 | 0.01k |
| Ex. 10 | $M_A$=Zn $M_B$=Ta | 0.930 | 0.020 | 0.050 | 99 | 0.01 |
| Comp. Ex. 1 | $M_A$=not used $M_B$=not used | 1.00 | 0.00 | 0.00 | 52.0 | 0.04M |
| Comp. Ex. 2 | $M_A$=not used $M_B$=W | 0.970 | 0.00 | 0.03 | 43.0 | 20M |
| Comp. Ex. 3 | $M_A$=not used $M_B$=Ta | 0.970 | 0.00 | 0.03 | 45.0 | 35M |
| Comp. Ex. 4 | $M_A$=Zn $M_B$=In | 0.67 | 0.25 | 0.08 | 96.0 | 0.02k |
| Comp. Ex.5 | $M_A$=Zn $M_B$=Ga | 0.61 | 0.21 | 0.18 | 95.0 | 0.04k |

TABLE 2: Composition, density and electric resistance of film

| | Used element | $(Sn) / (Sn+M_A+M_B)$ | $(M_A) / (Sn+M_A+M_B)$ | $(M_B) / (Sn+M_A+M_B)$ | Visible light transmittance (%) | Specific resistance ($\Omega$cm) |
|---|---|---|---|---|---|---|
| Ex. 1 | $M_A$=Zn $M_B$=Ta | 0.961 | 0.009 | 0.029 | 84.9 | 0.0055 |
| Ex. 2 | $M_A$=Zn $M_n$=Ta | 0.926 | 0.009 | 0.065 | 85.9 | 0.0032 |
| Ex. 3 | $M_A$=Zn $M_B$=Ta | 0.887 | 0.0010 | 0.103 | 86.4 | 0.0051 |
| Ex. 5 | $M_A$=Zn $M_B$=W | 0.926 | 0.009 | 0.065 | 86.6 | 0.0053 |
| Ex. 6 | $M_A$=Zn $M_B$=W | 0.887 | 0.010 | 0.103 | 87.2 | 0.0088 |

(continued)

|  | Used element | (Sn) / (Sn+M_A+M_B) | (M_A) / (Sn+M_A+M_B) | (M_B) / (Sn+M_A+M_B) | Visible light transmittance (%) | Specific resistance (Ωcm) |
|---|---|---|---|---|---|---|
| Ex. 7 | $M_A$=Nb $M_B$=Ta | 0.955 | 0.035 | 0.01 | 86.2 | 0.0043 |
| Ex. 8 | $M_A$=Nb $M_B$=W | 0.955 | 0.035 | 0.01 | 87.7 | 0.0065 |
| Ex. 9 | $M_A$=Zn $M_B$=Ta | 0.950 | 0.010 | 0.040 | 99 | 0.0032 |
| Ex. 10 | $M_A$=Zn $M_B$=Ta | 0.930 | 0.020 | 0.050 | 99 | 0.0033 |
| Comp. Ex. 4 | $M_A$=Zn $M_B$=In | 0.67 | 0.25 | 0.08 | 86.7 | 10.56 |
| Comp. Ex. 5 | $M_A$=Zn $M_B$=Ga | 0.61 | 0.21 | 0.18 | 87.2 | 1293.22 |

The sputtering target of the present invention is suitable for the formation of a transparent conductive film by DC sputtering method, DC pulse sputtering method and AC sputtering method.

The transparent conductive film obtained by the present invention is excellent in transparency and conductivity and has excellent properties required for transparent electrodes of FPD. Further, the transparent conductive film of the present invention does not contain expensive indium and thereby can be provided at a low cost. Since the transparent conductive film of the present invention does not contain antimony having toxicity, it is environmentally excellent. Further, in a case where the transparent conductive film is applied to the laser patterning technique, which is being remarkably developed in recent years, fine electrode patterns can be formed on glass, plastic substrate, film substrate or crystal substrate.

**Claims**

1. A sputtering target which is used for forming a transparent conductive film by a sputtering method, consisting of tin oxide as the main component, and at least
one element selected from the A dopant group consisting of zinc, titanium, magnesium and zirconium and at least one element selected from the B dopant group consisting of tungsten, tantalum and molybdenum, as dopants and containing no antimony or indium.

2. The sputtering target according to Claim 1, wherein the following formulae (1) to (3) are satisfied:

$$0.8 < (Sn)/(Sn+M_A+M_B) < 1.0 \qquad (1)$$

$$0.001 < (M_A)/(Sn+M_A+M_B) < 0.1 \qquad (2)$$

$$0.001 < (M_B)/(Sn+M_A+M_B) < 0.15 \qquad (3)$$

where $M_A$ is the total amount of elements of the A dopant group, $M_B$ is the total amount of elements of the B dopant group, and Sn is the amount of tin element contained in the sputtering target.

3. The sputtering target according to Claim 1 or 2, wherein the relative density is at least 60%, and the sheet resistance on its surface is at most 9E+6Ω/□.

4. A transparent conductive film, consisting of tin oxide as the main component, and at least one element selected from the A dopant group consisting of zinc, titanium, magnesium and zirconium and at least one element selected from the B dopant group consisting of tungsten, tantalum and molybdenum, as dopants and containing no antimony or indium.

5. The transparent conductive film according to Claim 4, wherein the following formulae (4) to (6) are satisfied:

$$0.8 < (Sn)/(Sn+M_A+M_B) < 1.0 \qquad (4)$$

$$0.001 < (M_A)/(Sn+M_A+M_B) < 0.1 \qquad (5)$$

$$0.001 < (M_B)/(Sn+M_A+M_B) < 0.15 \qquad (6)$$

where $M_A$ is the total amount of elements of the A dopant group, $M_B$ is the total amount of elements of the B dopant group, and Sn is the amount of tin element contained in the transparent conductive film.

6. The transparent conductive film according to Claim 4 or 5, wherein the specific resistance is at most 5E-2Ω cm.

7. The transparent conductive film according to any one of Claims 4 to 6, wherein the thickness of the transparent conductive film is at most 1 μm.

8. A display member, which has the transparent conductive film as defined in any one of Claims 4 to 7.

9. A method for producing a transparent conductive film, which comprises forming the transparent conductive film as defined in any one of Claims 4 to 7 by a sputtering method using the sputtering target as defined in any one of Claims 1 to 3.

**Patentansprüche**

1. Sputtertarget, das zur Bildung eines transparenten leitfähigen Films durch ein Sputterverfahren verwendet wird, welches aus Zinnoxid als Hauptkomponente und mindestens einem Element, ausgewählt aus der A-Dotierstoffgruppe, bestehend aus Zink, Titan, Magnesium und Zirkonium, und mindestens einem Element, ausgewählt aus der B-Dotierstoffgruppe, bestehend aus Wolfram, Tantal und Molybdän, als Dotierstoffe besteht, und das kein Antimon oder Indium enthält.

2. Sputtertarget nach Anspruch 1, bei dem die folgenden Formeln (1) bis (3) erfüllt sind:

$$0,8 < (Sn)/(Sn+M_A+M_B) < 1,0 \qquad (1)$$

$$0,001 < (M_A)/(Sn+M_A+M_B) < 0,1 \qquad (2)$$

$$0,001 < (M_B)/(Sn+M_A+M_B) < 0,15 \qquad (3)$$

wobei $M_A$ die Gesamtmenge von Elementen der A-Dotierstoffgruppe ist, $M_B$ die Gesamtmenge von Elementen der B-Dotierstoffgruppe ist und Sn die Menge des Elements Zinn ist, die in dem Sputtertarget enthalten ist.

3. Sputtertarget nach Anspruch 1 oder 2, bei dem die relative Dichte mindestens 60 % beträgt und der Flächenwiderstand auf dessen Oberfläche höchstens $9 \cdot 10^6$ Ω/□ beträgt.

4. Transparenter leitfähiger Film, der aus Zinnoxid als Hauptkomponente und mindestens einem Element, ausgewählt aus der A-Dotierstoffgruppe, bestehend aus Zink, Titan, Magnesium und Zirkonium, und mindestens einem Element, ausgewählt aus der B-Dotierstoffgruppe, bestehend aus Wolfram, Tantal und Molybdän, als Dotierstoffe besteht, und der kein Antimon oder Indium enthält.

5. Transparenter leitfähiger Film nach Anspruch 4, bei dem die folgenden Formeln (4) bis (6) erfüllt sind:

$$0,8 < (Sn)/(Sn+M_A+M_B) < 1,0 \qquad (4)$$

$$0,001 < (M_A)/(Sn+M_A+M_B) < 0,1 \qquad (5)$$

$$0,001 < (M_B)/(Sn+M_A+M_B) < 0,15 \qquad (6)$$

wobei $M_A$ die Gesamtmenge von Elementen der A-Dotierstoffgruppe ist, $M_B$ die Gesamtmenge von Elementen der B-Dotierstoffgruppe ist und Sn die Menge des Elements Zinn ist, die in dem transparenten leitfähigen Film enthalten ist.

6. Transparenter leitfähiger Film nach Anspruch 4 oder 5, bei dem der spezifische Widerstand höchstens $5 \cdot 10^{-2}$ Ω · cm beträgt.

7. Transparenter leitfähiger Film nach einem der Ansprüche 4 bis 6, wobei die Dicke des transparenten leitfähigen Films höchstens 1 μm beträgt.

8. Anzeigeelement, das den in einem der Ansprüche 4 bis 7 definierten transparenten leitfähigen Film aufweist.

9. Verfahren zur Herstellung eines transparenten leitfähigen Films, welches das Bilden des in einem der Ansprüche 4 bis 7 definierten transparenten leitfähigen Films durch ein Sputterverfahren unter Verwendung des in einem der Ansprüche 1 bis 3 definierten Sputtertargets umfasst.

**Revendications**

1. Une cible de pulvérisation cathodique qui est utilisée pour former un film transparent conducteur par une méthode de pulvérisation, composé d'oxyde d'étain comme composant principal, et d'au moins un élément choisi dans le groupe de dopants A composé de zinc, de titane, de magnésium et de zirconium et d'au moins un élément choisi dans le groupe de dopants B composé de tungstène, de tantale et de molybdène, comme dopants et ne contenant pas d'antimoine ou d'indium.

2. La cible de pulvérisation cathodique selon la Revendication 1, dans laquelle les formules suivantes (1) à (3) sont satisfaites :

$$0,8 < (Sn) / (Sn+M_A+M_B) < 1,0 \qquad (1)$$

$$0{,}001 < (M_A) / (Sn+M_A+M_B)<0{,}1 \qquad (2)$$

$$0{,}001 < (M_B) / (Sn+M_A+M_B)<0{,}15 \qquad (3)$$

où $M_A$ est le montant total des éléments du groupe de dopants A,
$M_B$ est le montant total des éléments du groupe de dopants B, et Sn est la quantité de l'élément d'étain contenu dans la cible de pulvérisation cathodique.

3.  La cible de pulvérisation cathodique selon la Revendication 1 ou 2, dans laquelle la densité relative est d'au moins 60%, et la résistance de couche à la surface est d'au plus 9E+6Ω/□.

4.  Un film transparent conducteur, composé d'oxyde d'étain comme composant principal, est d'au moins un élément choisi dans le groupe de dopants A composé de zinc, de titane, de magnésium et de zirconium et d'au moins un élément choisi dans le groupe de dopants B composé de tungstène, de tantale et de molybdène, comme dopants et ne contenant pas d'antimoine ou d'indium.

5.  Le film transparent conducteur selon la Revendication 4, dans lequel les formules suivantes (4) à (6) sont satisfaites :

$$0{,}8 < (Sn) / (Sn+M_A+M_B)<1{,}0 \qquad (4)$$

$$0{,}001 < (M_A) / (Sn+M_A+M_B)<0{,}1 \qquad (5)$$

$$0{,}001 < (M_B) / (Sn+M_A+M_B)<0{,}15 \qquad (6)$$

où $M_A$ est le montant total des éléments du groupe de dopants A,
$M_B$ est le montant total des éléments du groupe de dopants B, et Sn est la quantité de l'élément d'étain contenu dans le film transparent conducteur.

6.  Le film transparent conducteur selon la Revendication 4 ou 5, dans lequel la résistance spécifique est d'au plus 5E-2Ω cm.

7.  Le film transparent conducteur selon l'une quelconque des Revendications 4 à 6, dans lequel l'épaisseur du film transparent conducteur est d'au plus 1 μm.

8.  Un organe d'affichage, qui a le film transparent conducteur comme défini dans l'une quelconque des Revendications 4 à 7.

9.  Une méthode pour produire un film transparent conducteur, qui comprend la formation du film transparent conducteur comme défini dans l'une quelconque des Revendications 4 à 7 par une méthode de pulvérisation utilisant la cible de pulvérisation cathodique comme définie dans l'une quelconque des Revendications 1 à 3.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10330924 A
- JP 2000281431 A
- JP 2000273622 A
- WO 2005078152 A
- JP 2005154820 A

**Non-patent literature cited in the description**

- *Applied Physics Letters,* 2001, vol. 78 (3), 350